Europäisches Patentamt

European Patent Office

Office européen des brevets

(11) Veröffentlichungsnummer: **0 349 043 B1**

(12) **EUROPÄISCHE PATENTSCHRIFT**

(45) Veröffentlichungstag der Patentschrift: **02.03.94**

(51) Int. Cl.⁵: **G01R 27/28**

(21) Anmeldenummer: **89201600.7**

(22) Anmeldetag: **19.06.89**

(54) **Anordnung zur näherungsweisen Bestimmung des Ersatzschaltbildes eines elektrischen bzw. elektronischen Bauelementes bei hohen Frequenzen.**

(30) Priorität: **25.06.88 DE 3821575**

(43) Veröffentlichungstag der Anmeldung:
**03.01.90 Patentblatt 90/01**

(45) Bekanntmachung des Hinweises auf die
Patenterteilung:
**02.03.94 Patentblatt 94/09**

(84) Benannte Vertragsstaaten:
**DE FR GB NL**

(56) Entgegenhaltungen:
**FR-A- 2 561 390**

**IEEE TRANSACTIONS ON MICROWAVE THEORY AND TECHNIOUES, Band MTT-30, Nr. 5, Mai 1982, Seiten 661-666; J.C. TIPPET et al.: "A rigorous technique for measuring the scattering matrix of a multiport device with a 2-port network analyzer"**

**MICROWAVE JOURNAL, Band 24, Nr. 4, April 1981, Seiten 63-68; G.R. COBB: "New software for low loss two-part measurements"**

(73) Patentinhaber: **Philips Patentverwaltung GmbH**
Wendenstrasse 35c
D-20097 Hamburg(DE)

(84) Benannte Vertragsstaaten:
**DE**

(73) Patentinhaber: **N.V. Philips' Gloeilampenfabrieken**
**Groenewoudseweg 1**
**NL-5621 BA Eindhoven(NL)**

(84) Benannte Vertragsstaaten:
**FR GB NL**

(72) Erfinder: **Kerkow, Jörg**
**Bismarckstrasse 20**
**D-4018 Langenfeld(DE)**
Erfinder: **Pryschelski, Heinrich**
**Hermann-Löns-Strasse 33**
**D-5180 Eschweiler(DE)**

(74) Vertreter: **Kupfermann, Fritz-Joachim, Dipl.-Ing. et al**
**Philips Patentverwaltung GmbH**
**Wendenstrasse 35**
**Postfach 10 51 49**
**D-20035 Hamburg (DE)**

**Beschreibung**

Die Erfindung bezieht sich auf eine Anordnung zur näherungsweisen Bestimmung des Ersatzschaltbildes eines elektrischen bzw. elektronischen Bauelementes bei hohen Frequenzen mit einem Meßgerät, an welches ein ein Zweitorelement darstellendes Bauelement über Verbindungsglieder oder ein ein Eintorelement darstellendes Bauelement über ein Verbindungsglied angeschlossen ist und welches über einen vorgewählten Frequenzbereich die Parameter der Streumatrix des Zweitorelementes oder die Impedanz bzw. den Reflexionsfaktor des Eintorelementes mit dem oder den Verbindungsgliedern mißt.

Elektrische bzw. elektronische Bauelemente, die in Schaltungen eingesetzt werden, in denen Signale mit Frequenzen von über 10 MHz verarbeitet werden, weisen nicht nur die sie charakterisierende Eigenschaft (z.B. Widerstand, Induktivität, Kapazität, Verstärkung usw.) sondern auch parasitäre Eigenschaften auf. So hat z.B. ein Kondensator außer seiner gewünschten Kapazität auch mindestens eine induktive (parasitäre Induktivität) und eine ohmsche Komponente (parasitärer Widerstand). Ein Transistor, der ein Signal verstärken soll, weist beispielsweise mindestens eine kapazitive (parasitäre Kapazität), eine induktive (parasitäre Induktivität) und eine ohmsche Komponente (parasitärer Widerstand) auf. Um die Schaltung, in der das Bauelement verwendet wird, richtig zu dimensionieren, ist es erforderlich, dessen parasitäre Eigenschaften zu kennen. Zur Messung der Impedanz bzw. des Reflexionsfaktors eines Eintorelementes (z.B. Widerstand, Spule u.a.) wird ein Meßgerät (network analyzer) verwendet, das z.B. aus der GB-A 21 54 752 bekannt ist. Bei der Messung wird dem Eintorelement ein hochfrequentes Signal zugeleitet. Aus dem reflektierten Signal wird der Reflexionsfaktor oder die Impedanz ermittelt. Auch zur Messung der Streumatrix von Zweitorelementen, z.B. Transistoren, Bandpaßfilter u.a., ist ein solches Meßgerät vorgesehen. Die Eintor- bzw. Zweitorelemente werden an einen oder zwei Normanschlüsse (N-connector) des Meßgerätes über Verbindungsglieder angeschlossen. Solche Verbindungsglieder verfälschen durch von ihnen ausgehende parasitäre Einflüsse das Meßergebnis. Auch bestimmt ein solches Meßgerät kein Ersatzschaltbild des Eintor- bzw. Zweitorelementes, sondern mißt über einen vorgewählten Frequenzbereich den Real- und Imaginärteil bzw. die Amplitude und Phase der Impedanz bzw. des Reflexionsfaktors eines Eintorelementes oder die Parameter der Streumatrix eines Zweitorelementes.

Der Erfindung liegt daher die Aufgabe zugrunde, eine Anordnung zur näherungsweisen Bestimmung des Ersatzschaltbildes eines Bauelementes bei hohen Frequenzen zu schaffen, die den Einfluß des oder der Verbindungsglieder bei der Bestimmung der Werte der Ersatzschaltbildelemente eliminiert.

Die Aufgabe wird bei einer Anordnung der eingangs genannten Art dadurch gelöst, daß eine mit dem Meßgerät verbundene Auswerteschaltung vorgesehen ist, die

- das Meßergebnis durch Einbeziehung von vor der Messung ermittelten Zweitorparamtern des oder der Verbindungsglieder korrigiert und
- für ein Ersatzschaltbild des Bauelementes aus dem korrigierten Meßergebnis Werte der Ersatzschaltbildelemente durch eine Optimierungsstrategie berechnet.

Die in der erfindungsgemäßen Anordnung verwendete Auswerteschaltung, die mit dem Meßgerät verbunden ist, kann z.B. eine Mikroprozessorschaltung sein. Vor der Messung der Impedanz bzw. des Reflexionsfaktors eines Eintores oder der Parameter einer Streumatrix eines Zweitores sind Zweitorparameter des Verbindungsgliedes bzw. der Verbindungsglieder für jede Frequenzstelle des vorgewählten Frequenzbereiches in der Auswerteschaltung abgespeichert worden. Solche Zweitorparameter können z.B. eine Impedanzmatrix, eine Admittanzmatrix, eine Kettenmatrix, eine Streumatrix oder eine andere das Verbindungsglied beschreibende Matrix sein. Die Zweitorparameter des Verbindungsgliedes an jeder Frequenzstelle können bekannt sein und vor der Messung in die Auswerteschaltung eingelesen werden oder vor der eigentlichen Messung durch Vormessungen ermittelt werden.

Nach der eigentlichen Messung wird das Meßergebnis korrigiert. Die durch das Verbindungsglied bzw. die Verbindungsglieder hervorgerufene Verfälschung des Meßergebnisses wird eliminiert. Nach Bestimmung des korrigierten Meßergebnisses werden für ein Ersatzschaltbild die Werte der Ersatzschaltbildelemente berechnet. Das Ersatzschaltbild kann vor der Messung angegeben werden oder die Auswerteschaltung kann das geeignete Ersatzschaltbild unter mehreren bestimmen. Die Berechnung erfolgt dabei mit Hilfe einer Optimierungsstrategie. Hierbei werden aus Anfangswerten für ein Eintorelement die Impedanz bzw. der Reflexionsfaktor oder für ein Zweitorelement die Streumatrix für eine Anzahl von Frequenzstellen über den vorgewählten Frequenzbereich ermittelt. Mittels einer Fehlerfunktion stellt die Auswerteschaltung eine Abweichung zwischen berechnetem und gemessenem Ergebnis fest und verändert die Anfangswerte so, daß die Abweichung verringert wird. Als Fehlerfunktion F kann die folgende Gleichung, die eine Mittelung der quadratischen Fehler bewirkt, verwendet werden:

$$F = \left[ \frac{\sum_{i=1}^{m} \left[ \frac{y(fi) - x(fi)}{x(fi)} \right]^2}{m} \right]^{\frac{1}{2}} , \qquad (1)$$

wobei x(fi) das Meßergebnis, y(fi) das berechnete Ergebnis an der Frequenzstelle fi und um die Anzahl der Frequenzstellen ist. Als Optimierungsstrategien lassen sich z.B. Gradientenmethoden, Koordinatensuchmethoden u.a. verwenden. Hierzu ist näheres z.B. aus dem Buch "Optimierungsverfahren" von W. Entenmann, Dr. Alfred Hüthig Verlag Heidelberg, UTB-Taschenbuch 539, 1976, zu entnehmen.

In einer Weiterbildung der Erfindung ist vorgesehen, daß die Auswerteschaltung aus der gemessenen Impedanz des Eintorelementes mit dem Verbindungsglied und den Parametern der Admittanzmatrix des Verbindungsgliedes die Impedanz des Eintorelementes für jede vorgewählte Frequenzstelle berechnet, wobei für jede Frequenzstelle Parameter der Admittanzmatrix vor der eigentlichen Messung durch eine Kurzschlußmessung, eine Leerlaufmessung und eine Messung mit einem Normwiderstand bestimmt worden sind. Die Impedanz Zd des Eintorelementes an jeder Frequenzstelle berechnet die Auswerteschaltung nach der folgenden Gleichung aus der Admittanzmatrix Y des Verbindungsgliedes und der Impedanz Zm des Eintorelementes mit dem Verbindungsglied:

$$Zd = \frac{1 - y\,Zm}{Zm\,\det(Y) - Y22} , \qquad (2)$$

wobei y11 und y22 Parameter und det(Y) die Determinante der Admittanzmatrix Y an einer Frequenzstelle sind. Die Admittanzmatrix kann vor der eigentlichen Messung ermittelt werden, in dem drei Messungen, nämlich bei Kurzschluß, Leerlauf und Abschluß mit einem Normwiderstand (z.B. 50 Ohm) durchgeführt werden.

In einer anderen Weiterbildung der Erfindung ist vorgesehen, daß die Auswerteschaltung aus der gemessenen Streumatrix des Zweitorelementes mit den Verbindungsgliedern und den Parametern der Admittanzmatrix jedes Verbindungsgliedes die Parameter der Admittanzmatrix des Zweitorelementes für jede vorgewählte Frequenzstelle berechnet, wobei für jede Frequenzstelle Parameter der Admittanzmatrix jedes Verbindungsgliedes vor der eigentlichen Messung durch eine Kurzschlußmessung, eine Leerlaufmessung und eine Messung mit Normwiderstand bestimmt worden sind. Hierbei wird von der Auswerteschaltung in ähnlicher Weise, wie bei der Berechnung der Impedanz des Eintorelementes, die Admittanzmatrix des Zweitorelementes an jeder Frequenzstelle ohne Verbindungsglieder bestimmt.

Bei der Messung der Streumatrix des Zweitorelementes kann Energie, insbesondere bei einer geringen Entfernung zwischen den Verbindungsgliedern, nicht nur über das Zweitor, sondern auch über den freien Raum übertragen werden. Daher ist vorgesehen, daß die Auswerteschaltung bei der Berechnung der Admittanzmatrix des Zweitorelementes zusätzlich die Parameter der Admittanzmatrix einbezieht, welche die Kopplung zwischen den Verbindungsgliedern beschreibt, wobei die Parameter dieser Admittanzmatrix vor der eigentlichen Messung durch eine Messung der Streumatrix an jeder Frequenzstelle bei leerlaufenden Anschlüssen der beiden Verbindungsglieder bestimmt worden sind. Es wird also vor der eigentlichen Messung eine Vormessung der Streumatrix an jeder Frequenzstelle durchgeführt, die sich bei offenen Anschlüssen, d.h. bei Abwesenheit des Zweitores, ergibt.

Vorzugsweise wird als Optimierungsstrategie eine Koordinatensuchmethode verwendet, welche auf einfache Art von der Auswerteschaltung durchzuführen ist. Hierbei ist vorgesehen, daß die Auswerteschaltung

- nacheinander alle Anfangswerte der Ersatzschaltbildelemente um einen Teil des Wertes verändert,
- nach der Veränderung eines Wertes die Admittanzmatrix des Zweitorelementes oder die Impedanz des Eintorelementes an jeder Frequenzstelle berechnet,

- das berechnete Ergebnis mit dem korrigierten Meßergebnis vergleicht,
- die Veränderung der Werte der Ersatzschaltbildelemente solange fortsetzt, bis die Abweichung zwischen dem korrigierten Meßergebnis und dem berechneten Ergebnis nicht weiter verringerbar ist und
- die zuletzt festgelegten Werte der Ersatzschaltbildelemente ausgibt.

Beim Start der Optimierungsstrategie berechnet die Auswerteschaltung beispielsweise aus den vor der Messung festgelegten Anfangswerten die Impedanz eines Eintores und vergleicht mittels einer Fehlerfunktion die Abweichung zwischen dem berechneten Ergebnis und dem Meßergebnis. Danach verändert die Auswerteschaltung den Wert eines Ersatzschaltbildes um einen Teil des Wertes (z.B. 5 %) in positiver Richtung. Anschließend wird erneut die Impedanz des Eintores berechnet. Ergibt sich eine verringerte Abweichung über den gesamten vorgewählten Frequenzbereich, verändert die Auswerteschaltung den Wert eines anderen Ersatzschaltbildelementes. Erfolgte aber keine Verringerung, wird eine Veränderung um denselben Betrag in negativer Richtung vorgenommen und erneut die Abweichung festgestellt. Ergibt sich eine geringere Abweichung, wird der veränderte Wert an Stelle des alten Wertes übernommen. Diese Strategie wird mit jedem Ersatzschaltbildelement fortgesetzt. Wenn alle Ersatzschaltbildelemente so verändert worden sind, daß sich eine Minimierung der Abweichung über den vorgewählten Frequenzbereich ergibt, wird diese Prozedur von neuem begonnen und solange wiederholt, bis keine weitere Verringerung erfolgt. Die zuletzt ermittelten Werte der Ersatzschaltbildelemente stellen dann eine näherungsweise Bestimmung der Werte des Ersatzschaltbildes des Bauelementes bei hohen Frequenzen dar. Zusätzlich kann noch der mittlere quadratische Fehler der Näherung ermittelt und ausgegeben werden.

In vielen Fällen ist es nicht möglich, vor der Messung abzuschätzen, welches Ersatzschaltbild für das zu messende Bauelement am geeignetsten ist. Daher ist vorgesehen, daß die Auswerteschaltung

- die näherungsweise Bestimmung der Werte für die Ersatzschaltbildelemente für verschiedene Ersatzschaltbilder durchführt und
- die Werte der Ersatzschaltbildelemente für das Zweitorelement bzw. Eintorelement ausgibt, bei welchem die geringste Abweichung zwischen Meßergebnis und berechnetem Ergebnis auftritt.

Hierbei werden für verschiedene Ersatzschaltbildelemente die Werte mit einer Optimierungsstrategie berechnet. Es wird dann dasjenige Ersatzschaltbild ausgegeben, bei dem sich nach der Optimierung die geringste Abweichung zwischen dem berechneten Ergebnis und dem Meßergebnis ergibt.

Ausführungsbeispiele der Erfindung werden nachstehend anhand der Zeichnungen näher erläutert. Es zeigen:

Fig. 1 eine Anordnung zur näherungsweisen Bestimmung des Ersatzschalbildes eines Eintorbauelementes,

Fig. 2 ein Verbindungsglied, welches das Bauelement mit dem in Fig. 1 verwendeten Meßgerät verbindet,

Fig. 3 eine Zweitorschaltung zur Erläuterung der Zweipolparameter des Verbindungsgliedes,

Fig. 4 ein Flußablaufdiagramm, welches die Berechnung der Werte der Ersatzschaltbildelemente in der in Fig. 1 dargestellten Auswerteschaltung zeigt und

Fig. 5 eine Anordnung zur näherungsweisen Bestimmung des Ersatzschaltbildes eines Zweitor-Bauelementes.

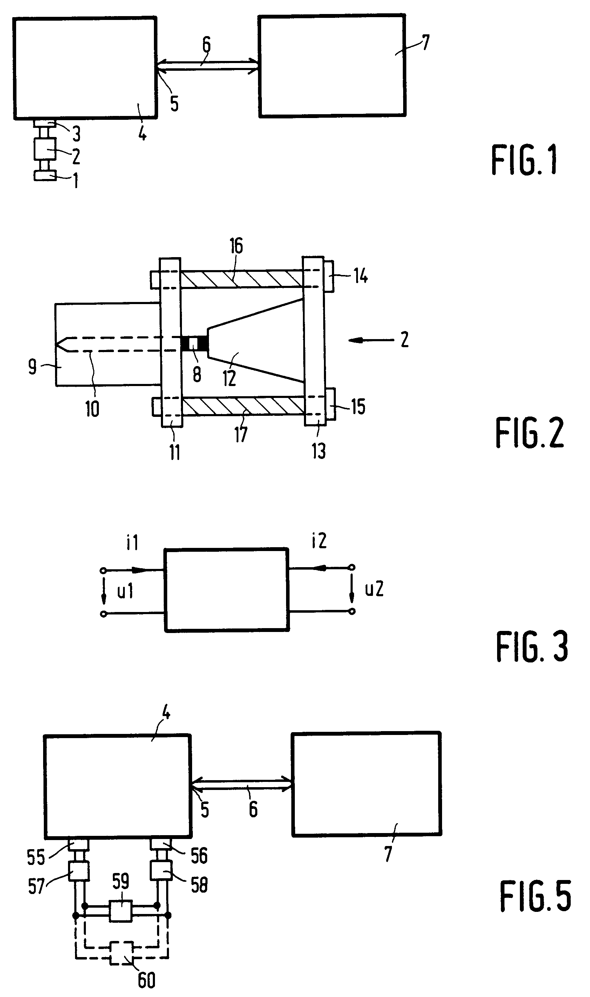

Die in Fig. 1 dargestellte Anordnung dient zur näherungsweisen Bestimmung des Ersatzschaltbildes eines Bauelementes 1, das über ein Verbindungsglied 2, mit einem Eingang 3 eines Meßgerätes 4 verbunden ist. Das Meßgerät 4 mißt den Real- und Imaginärteil bzw. die Amplitude und Phase der Impedanz des aus dem Eintorelement 1 und dem Verbindungsglied 2 gebildeten Meßelementes an vorgewählten Frequenzstellen eines Frequenzbereiches. Der Eingang 3 des handelsüblichen Meßgerätes 4 (z.B. Hewlett Packard HP 8542 A) ist ein Normeingang (N-connector), an den das Eintor-Bauelement 1 über ein an diesen Normeingang angepaßtes Verbindungsglied 2 angeschlossen ist. Des weiteren verfügt das Meßgerät 4 über einen Ausgang 5, an dem die gemessenen Daten als digitale Abtastwerte ausgelesen werden können. Der Ausgang 5 ist mit einer Auswerteschaltung 7 verbunden, die als Digitalrechenanordnung ausgebildet ist. Die Auswerteschaltung 7 enthält eine zentrale Recheneinheit, z.B. einen Mikroprozessor, mindestens einen Schreib/Lesespeicher (RAM), mindestens einen Festwertspeicher (ROM), einen Eingabe- und einen Ausgabebaustein. Die Auswerteschaltung kann noch mit weiteren externen Speicherschaltungen verbunden sein, z.B. einem Festplattenlaufwerk und einer Ausgabeeinheit in Form eines Bildschirmes oder eines Druckers. Die von dem Meßgerät ermittelten Werte der Impedanz und die entsprechenden Frequenzstellen werden über die Leitung 6 der Digitalrechenanordnung 7 zugeführt.

Ein Beispiel für ein Verbindungsglied 2, das einen SMD-Widerstand 8 mit dem Eingang 3 des Meßgerätes 4 verbindet, ist in Fig. 2 dargestellt. Der Eingang 3 des Meßgerätes 4 besteht aus einem kreisrunden Rohr mit Außengewinde und einem im Zentrum liegenden Rohr mit geringerem Durchmesser.

Das Verbindungsglied 2 enthält ein Rohr mit Innengewinde, das auf den Normanschluß 3 aufgeschraubt wird und einen ersten Anschluß des Verbindungsgliedes 2 darstellt. Der zweite Anschluß des Verbindungsgliedes 2 liegt im Zentrum des kreisförmigen Rohres 9 und ist als Stift 10 ausgebildet, der in das im Zentrum des Rohres des Einganges 3 liegende Rohr eingreift. Das Rohr 9 und der Stift 10 enden in einer Platte 11, die z.B. aus Messing besteht. Im Zentrum der Platte 11 ist eine Bohrung vorhanden, in die der Stift 10 eingepaßt ist. Der Stift 10 ist dabei durch eine Isolierschicht von der Platte 11 isoliert. Der Teil des Stiftes 10, der in der Platte 11 gehaltert ist, dient als erster Kontaktpunkt für den SMD-Widerstand 8. Der andere Kontaktpunkt des quaderförmigen SMD-Widerstandes ist mit einem keilförmigen Messingstück 12 verbunden, das in einer Platte 13 endet, die als Gegenstück zur Platte 11 ausgebildet ist. Die Platten 11 und 13 weisen jeweils zwei Bohrlöcher auf. Die Bohrlöcher der Platten 11 und 13 dienen zur Aufnahme zweier Schrauben 14 und 15, welche die Platten 11 und 13 verbinden. Zwischen den Platten 11 und 13 und um die Schrauben 14 und 15 sind Stahlfedern 16 und 17 angebracht, die eine Spannung auf die Platten 11 und 13 ausüben. Das Rohr 9, das den anderen Anschluß darstellt, ist mit dem zweiten Kontakt des SMD-Bauelementes 8 über das Messingstück 12, die Platte 13, die Schrauben 14 und 15 und die Platte 11 kontaktiert.

Nach der Messung der Impedanz des Eintorelementes 1 mit dem Verbindungsglied 2 werden in der Auswerteschaltung 7 aus den gemessenen Impedanzwerten Werte für die Ersatzschaltbildelemente berechnet. Bei der Messung treten durch parasitäre Einflüsse des Verbindungsgliedes 2 Verfälschungen des Meßergebnisses auf. Daher muß vor der Bestimmung der Werte der Ersatzschaltbildelemente eine Korrektur der Meßergebnisse vorgenommen werden. Hierzu sind vor der Messung in die Auswerteschaltung 7 Parameter der Admittanzmatrix bei jeder Frequenzstelle eingegeben worden. Es ist auch möglich, wie im folgenden beschrieben wird, vor der Messung durch Vormessungen die Parameter der Admittanzmatrix bei jeder Frequenzstelle zu bestimmen. Hierbei wird zuerst eine Kurzschlußmessung an jeder Frequenzstelle durchgeführt und die ermittelten Meßwerte abgespeichert. Anschließend wird eine Leerlaufmessung an jeder Frequenzstelle und dann eine Messung durchgeführt, bei der das Verbindungsglied 2 mit einem Normwiderstand von ungefähr 50 Ohm abgeschlossen ist. Der Normwiderstand, der bekannt ist, weist einen kleinen, aber nicht vernachlässigbaren induktiven und kapazitiven Anteil auf. Die Kurzschlußmessung wird mit einem Metallstück durchgeführt, das die Anschlüsse des Verbindungsgliedes 2 verbindet. Auch ein solches Metallstück weist einen bekannten induktiven Anteil und einen geringen bekannten frequenzabhängigen Widerstand auf. Nach den drei Messungen bei jeder Frequenzstelle kann die Admittanzmatrix an jeder Frequenzstelle bestimmt werden.

Die Admittanzmatrix wird durch die Parameter $y11$, $y12$, $y21$ und $y22$ für ein Zweitor beschrieben und wird durch die beiden folgenden Gleichungen definiert:

$$i1 = y11\, u1 + y12\, u2 \qquad (3)$$

$$i2 = y21\, u1 + y22\, u2 \qquad (4)$$

In Fig. 3 ist ein Zweitor mit den Spannungen $u1$, $u2$, $i1$ und $i2$ dargestellt, welches durch die Gleichungen (3) und (4) charakterisiert wird. Die Determinante $\det(Y)$ ist durch die folgende Gleichung gegeben:

$$\det(Y) = y11\, y22 - y12\, y21 \, . \qquad (5)$$

Für passive Zweipole gilt noch die Beziehung: $y12 = y21$.

Nach den Kurzschlußmessungen, Leerlaufmessungen und Messungen mit Normwiderstand kann bei jeder Frequenzstelle aus den folgenden drei Gleichungen die Admittanzmatrix Y berechnet werden:

$$det(Y) = \frac{Zm0 - Zm50}{Zm50 \; Zd0 \; Zmu - Zm50 \; Zd0 \; Zm0 + Zm0 \; Zd50 \; (Zm50 - Zmu)} \; , \quad (6)$$

$$y22 = det(Y) \; Zmu \; , \qquad (7)$$

$$y11 = \frac{1 - det(Y) \; Zd50 \; (Zm50 - Zmu)}{Zm50} \; , \quad (8)$$

wobei Zmu die Impedanz des Verbindungsgliedes 2 bei Leerlauf ist; Zd0 die Impedanz eines Metallstückes ist, das als Kurzschlußabschluß dient und einen Widerstand in der Nähe von 0 Ohm hat; Zm0 die Impedanz des mit dem Metallstück abgeschlossenen Verbindungsgliedes 2 (Kurzschluß) ist; Zd50 die Impedanz des Normwiderstandes ist, die in der Nähe von 50 Ohm liegt; Zm50 die Impedanz des Verbindungsgliedes 2 bei Abschluß mit dem Normwiderstand ist. In der Praxis, d.h. bei realen Verhältnissen, weisen der Normwiderstand und das als Kurzschluß dienende Metallstück - wie oben erwähnt - geringe parasitäre Anteile auf, die aber nicht vernachlässigbar sind, und bei der Berechnung berücksichtigt werden müssen. Die Impedanzen des Messingplättchens und des Normwiderstandes sind bekannt. Die Impedanz des Leerlaufes wird als unendlich angenommen.

Die Impedanz Zd des Eintorelementes 1 kann aus der folgenden Gleichung bei jeder Frequenzstelle bestimmt werden:

$$Zd = \frac{1 - y11 \; Zm}{Zm \; det(Y) - y22} \; , \qquad (9)$$

wobei Zm die Impedanz des mit dem zu messenden Eintorelement 1 abgeschlossenen Verbindungsgliedes 2 ist.

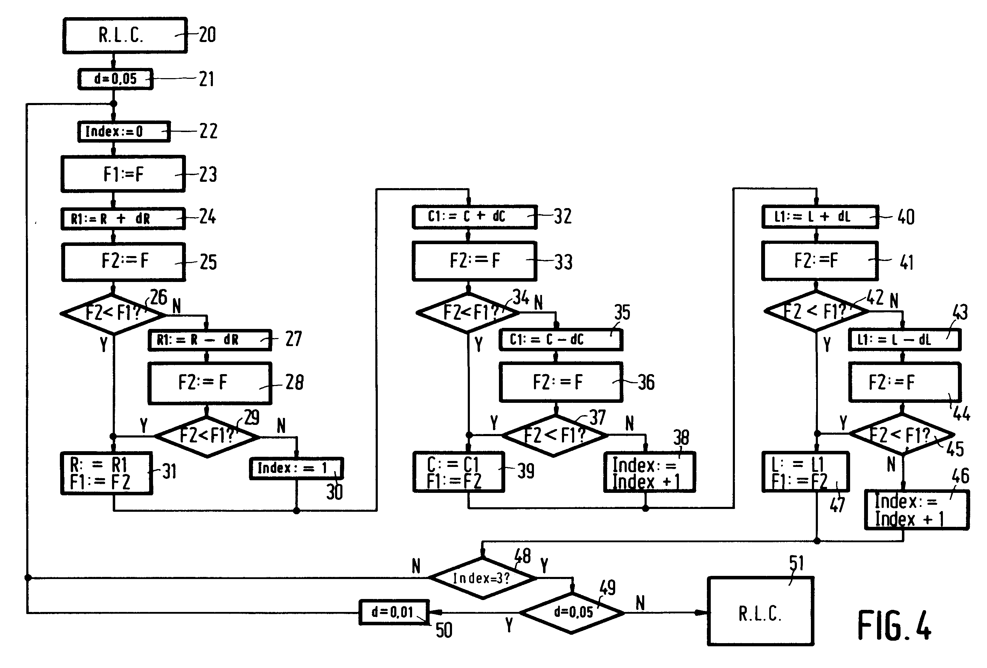

Nachdem die Auswerteschaltung 7 die Werte für die Impedanz Zd an jeder Frequenzstelle für das Eintorelement 1 berechnet hat, wird eine Optimierungsstrategie angewendet, um die Werte für die Ersatzschaltbildelemente zu erhalten. Vor der Messung der mit Hilfe des Verbindungsgliedes 2 ermittelten Impedanz des SMD-Widerstandes 8, wurde als Ersatzschaltbild eine Schaltung mit einer Parallelschaltung aus Widerstand R und Kondensator C und einer dazu in Reihe geschalteten Spule L gewählt. Mit Hilfe des Flußablaufdiagrammes in Fig. 4 wird erläutert, wie die Auswerteschaltung 7 die Werte der Ersatzschaltbildelemente näherungsweise bestimmt.

Die Impedanz Zd des Eintorelementes 1 ist als Real- und Imaginärteil gemessen worden. Als Anfangswerte für den Widerstand R wird der Mittelwert des Realteiles der Impedanz gewählt. Für die Kapazität C und für die Induktivität L sind vor der Messung Anfangswerte angegeben worden.

In Fig. 4 ist die Festlegung der Anfangswerte in Block 20 dargestellt. Im nächsten Programmschritt (Block 21) wird die zuerst vorzunehmende Änderung der Bauelemente mit d = 0,05, d.h. eine fünfprozentige Abweichung festgelegt. Zuerst wird die Variable "Index" gleich Null gesetzt (Block 22) und für die Werte des Widerstandes R ,der Spule L und der Kapazität C die Impedanz des Ersatzschaltbildes bei den vorgewählten Frequenzstellen berechnet und eine Fehlerfunktion F berechnet (Block 23). Mittels der Fehlerfunktion F wird eine Abweichung zwischen der berechneten Impedanz und der gemessenen Impedanz an den Frequenzstellen festgestellt. Die Fehlerfunktion F wird durch folgende Gleichung beschrieben:

$$F = \left[ \frac{\sum_{i=1}^{m} \left[ \frac{y(fi) - x(fi)}{x(fi)} \right]^2}{m} \right]^{\frac{1}{2}} , \qquad (10)$$

wobei x(fi) die gemessene Impedanz, y(fi) die berechnete Impedanz an der Frequenzstelle fi und m die Anzahl der Frequenzstellen ist. Wie in Block 24 beschrieben, wird anschließend zum Widerstandswert R ein Widerstandswert dR addiert und es ergibt sich ein neuer Widerstand R1. Mit diesem Widerstand R1 wird erneut die Impedanz und dann die Fehlerfunktion berechnet (Block 25). Die zuletzt berechnete Fehlerfunktion F wird als Funktion F2 festgelegt. Anschließend findet ein Vergleich (Block 26) zwischen der in Block 23 berechneten Fehlerfunktion F1 mit der Fehlerfunktion F2 statt. Ist die Fehlerfunktion F2 nicht kleiner als die Fehlerfunktion F1, ist die Abweichung zwischen der berechneten Impedanz und der gemessenen Impedanz nicht geringer geworden. Daher wird, wie in Block 27 dargestellt ist, der Widerstand R um den Widerstand dR verringert. Mit dem sich so ergebenden neuen Widerstandswert R1 wird erneut die Impedanz und die Fehlerfunktion F berechnet. Die Fehlerfunktion F wird gleich F2 gesetzt (Block 28) und es findet ein erneuter Vergleich (Block 29) zwischen der Fehlerfunktion F2 und der Fehlerfunktion F1 statt. Ist die Fehlerfunktion F2 nicht kleiner als die Fehlerfunktion F1, hat sich keine Minimierung ergeben und in Block 30 wird die Variable "Index" gleich 1 gesetzt. Ist die Abweichung zwischen berechneten und gemessenen Ergebnis geringer geworden - entweder durch eine Minimierung in positiver (Block 24) oder in negativer Richtung (Block 27) - wird der veränderte Widerstandswert R1 gleich dem Widerstandswert R und die Fehlerfunktion F2 gleich der Fehlerfunktion F1 gesetzt (Block 31), da sich eine verringerte Abweichung mit dem neuen Widerstandswert R1 ergab.

In den nächsten Programmschritten wird eine Veränderung der Kapazität C vorgenommen und versucht, eine verminderte Abweichung zu erreichen. Zuerst wird, wie in Block 32 dargestellt ist, die Kapazität C um einen Wert dC vergrößert. Es ergibt sich eine Kapazität C1. Anschließend wird die Impedanz und die Fehlerfunktion F berechnet, die dann gleich F2 gesetzt wird (Block 33). In Block 34 ist der Vergleich zwischen der Fehlerfunktion F1 und der zuletzt berechneten Fehlerfunktion F2 dargestellt. Wird festgestellt, daß die Fehlerfunktion F2 nicht kleiner ist als die Fehlerfunktion F1, wird die Kapazität C um die Kapazität dC verringert und es ergibt sich eine neue Kapazität C1 (Block 35). Anschließend wird die neue Impedanz und eine Fehlerfunktion berechnet, die gleich F2 gesetzt wird (Block 36). Wie in Block 37 dargestellt ist, findet anschließend der Vergleich zwischen der Fehlerfunktion F2 und der Fehlerfunktion F1 statt. Ergibt sich auch hier, daß die Fehlerfunktion F2 nicht kleiner ist als die Fehlerfunktion F1, wird, wie das Block 38 zeigt, die Variable "Index" um 1 erhöht. Falls aber die Fehlerfunktion F2 in Block 34 oder in Block 37 kleiner ist als die Fehlerfunktion F1, wird die berechnete Kapazität C1 gleich der Kapazität C und die zuletzt berechnete Fehlerfunktion F2 gleich der Fehlerfunktion F1 gesetzt.

Die Veränderung der Induktivität L in den anschließenden Programmschritten wird ähnlich durchgeführt, wie das bei der Veränderung der Kapazität C und des Widerstandes R erfolgt ist. Zuerst wird, wie das in Block 40 dargestellt ist, die Induktivität L um einen Betrag dL erhöht, so daß sich eine Induktivität L1 ergibt. Block 41 zeigt die Berechnung der Impedanz und die der Fehlerfunktion F, die noch gleich F2 gesetzt wird. In dem anschließenden Vergleich (Block 42) wird wiederum die Fehlerfunktion F1 mit der neu berechneten Fehlerfunktion F2 verglichen. Ergibt sich, daß die Fehlerfunktion F2 nicht kleiner ist als die Fehlerfunktion F1, wird, wie das in Block 43 gezeigt ist, die Induktivität L um die Induktivität dL vermindert. Mit der so berechneten Induktivität L1 wird eine neue Impedanz und anschließend eine neue Fehlerfunktion F berechnet, die gleich F2 gesetzt wird (Block 44). Wie Block 45 zeigt, wird anschließend der Vergleich zwischen der neu berechneten Fehlerfunktion F2 und der Fehlerfunktion F1 durchgeführt. Ist die Fehlerfunktion F2 nicht kleiner als die Fehlerfunktion F1, wird die Variable "Index" um 1 erhöht (Block 46). Wird bei dem Vergleich der Fehlerfunktionen in Block 42 oder in Block 45 festgestellt, daß die Fehlerfunktion F2 kleiner ist als die Fehlerfunktion F1, wird, wie das in Block 47 gezeigt ist, die neu berechnete Induktivität L1 gleich der Induktivität L und die zuletzt berechnete Fehlerfunktion F2 gleich der Fehlerfunktion F1 gesetzt.

Nach Berechnung der Induktivität wird anschließend in Block 48 überprüft, ob die Variable "Index" gleich 3 ist. Ist die Variable "Index" gleich 3, ergab sich keine verminderte Abweichung bei der Widerstands-, Kapazitäts- und Induktivitätsberechnung. In diesem Fall wird die Variable d, wie das aus den Blöcken 49 und 50 ersichtlich ist, auf den Wert 0,01 verringert, was einer einprozentigen Änderung entspricht. Falls aber die Berechnung schon mit diesem Wert d = 0,01 durchgeführt worden ist, werden die zuletzt berechneten Widerstands-, Kapazitäts- und Induktivitätswerte, wie das Block 51 zeigt, ausgelesen. Diese Werte stellen dann die Näherungswerte für die Ersatzschaltbildelemente dar. Falls in Block 48 festgestellt worden ist, daß die Variable "Index" nicht gleich 3 ist, wird mit dem Programmschritt in Block 22 fortgefahren. Ebenfalls wird, wenn die Variable d noch nicht gleich 0,01 ist, mit einer Berechnung ab Block 22 weitergemacht.

In vielen Fällen ist es nicht möglich, vor der Messung anzugeben, welches Ersatzschaltbild für das zu messende Bauelement am geeignetsten ist. Daher kann das Programm, welches in der Auswerteschaltung 7 durchgeführt wird, so umgestaltet werden, daß verschiedene Ersatzschaltbilder berechnet werden und das Ersatzschaltbild für das gemessene Bauelement verwendet wird, bei welchem die geringste Abweichung zwischen den gemessenen und berechneten Werten vorkommt.

In Fig. 5 ist eine Anordnung zur näherungsweisen Bestimmung des Ersatzschaltbildes eines Zweitorelements 59 bei hohen Frequenzen dargestellt. Diese Anordnung enthält ebenfalls das Meßgerät 4 und die Auswerteschaltung 7. Das Meßgerät 4 und die Auswerteschaltung 7 sind über die Leitung 6 miteinander verbunden. Das Meßgerät weist zwei Eingänge 55 und 56 auf, an die jeweils ein Verbindungsglied 57 und 58 angeschlossen ist. An die anderen Tore der Verbindungsglieder 57 und 58 ist das zu messende Zweitorelement 59 angeschlossen. Das Meßgerät 4 mißt die Streumatrix der beiden Vierpolelemente 57 und 58 und des Zweitores 59 an den vorgewählten Frequenzstellen. Um die Streumatrix an den vorgewählten Frequenzstellen für das Zweitorelement 59 zu bekommen, muß ebenfalls eine Korrektur der Meßergebnisse vorgenommen werden. Hierbei wird für jedes Verbindungsglied 57 bzw. 58 eine Kurzschlußmessung, eine Leerlaufmessung und eine Messung mit Normwiderstand an jeder Frequenzstelle durchgeführt.

Des weiteren muß eine Messung der Streumatrix bei Abwesenheit eines Zweitores zwischen den Toren der Verbindungsglieder 57 und 58 durchgeführt werden, die normalerweise mit dem zu messenden Zweitorelement verbunden sind. Zwischen den Verbindungsgliedern, insbesondere bei geringen Abständen, tritt ein Energieaustausch nicht nur über das Zweitor 59 sondern auch über den das Zweitorelement 59 umgrenzenden Raum (fiktives Verbindungsglied 60) auf. Nach Berechnung der Streumatrix der gesamten Kette, nämlich der Verbindungsglieder 57 und 58 und des parallel zum Zweitorelement 59 angeordneten fiktiven Verbindungsgliedes 60 wird aus der ermittelten Streumatrix zu jeder Frequenzstelle eine Admittanzmatrix berechnet. Die Admittanzmatrix für das fiktive Verbindungsglied 60 läßt sich nun nach folgender Methode ermitteln. Aus der Gesamtadmittanzmatrix der Verbindungsglieder 57, 58 und 60 und der Admittanzmatrix eines Verbindungsgliedes, z.B. 57, läßt sich die Admittanzmatrix der Verbindungsglieder 58 und 60 an einer Frequenzstelle ermitteln. Anschließend wird die Admittanzmatrix des fiktiven Verbindungsgliedes 60 ermittelt. Dabei wird aus der Gesamtadmittanzmatrix der Verbindungsglieder 58 und 60 und der Admittanzmatrix des Verbindungsgliedes 58 die Admittanzmatrix des fiktiven Verbindungsgliedes 60 berechnet. Die einzelnen Admittanzmatrizen an jeder Frequenzstelle für die Verbindungsglieder 57, 58 und 60 werden in der Auswerteschaltung 7 abgespeichert. Nach Messung der Streumatrix des Zweitorelementes 59 mit dem Verbindungsgliedern 57, 58 und 60 wird eine Korrekturrechnung durchgeführt, welche die Admittanzmatrix an jeder Frequenzstelle des Zweitorelementes 59 ermittelt. Anschließend kann eine Optimierungsstrategie zur Ermittlung der Werte der Ersatzschaltbildelemente durchgeführt werden. Diese Berechnung wird in ähnlicher Weise, wie das in Fig. 4 dargestellt ist, durchgeführt.

## Patentansprüche

1. Anordnung zur näherungsweisen Bestimmung des Ersatzschaltbildes eines elektrischen bzw. elektronischen Bauelementes bei hohen Frequenzen, mit einem Meßgerät (4), an welches ein ein Zweitorelement (59) darstellendes Bauelement über Verbindungsglieder (57, 58, 60) oder ein ein Eintorelement (1) darstellendes Bauelement über ein Verbindungsglied (2) angeschlossen ist und welches über einen vorgewählten Frequenzbereich die Parameter der Streumatrix des Zweitorelementes (59) oder die Impedanz bzw. den Reflexionsfaktor des Eintorelementes (1) mit dem oder den Verbindungsgliedern (2; 57, 58, 60) mißt,

dadurch gekennzeichnet, daß eine mit dem Meßgerät (4) verbundene Auswerteschaltung (7) vorgesehen ist, die

- das Meßergebnis durch Einbeziehung von vor der Messung ermittelten Zweitorparametern des oder der Verbindungsglieder (2; 57, 58, 60) korrigiert und

- für ein Ersatzschaltbild des Bauelementes (1, 59) aus dem korrigierten Meßergebnis Werte der Ersatzschaltbildelemente durch eine Optimierungsstrategie berechnet.

**2.** Anordnung nach Anspruch 1,
dadurch gekennzeichnet, daß die Auswerteschaltung (7) aus der gemessenen Impedanz des Eintorelementes (1) mit dem Verbindungsglied (2) und den Parametern der Admittanzmatrix des Verbindungsgliedes die Impedanz des Eintorelementes für jede vorgewählte Frequenzstelle berechnet, wobei für jede Frequenzstelle Parameter der Admittanzmatrix vor der eigentlichen Messung durch eine Kurzschlußmessung, eine Leerlaufmessung und eine Messung mit einem Normwiderstand bestimmt worden sind.

**3.** Anordnung nach Anspruch 1,
dadurch gekennzeichnet, daß die Auswerteschaltung (7) aus der gemessenen Streumatrix des Zweitorelementes (59) mit den Verbindungsgliedern (57, 58) und den Parametern der Admittanzmatrix jedes Verbindungsgliedes die Parameter der Admittanzmatrix des Zweitorelementes für jede vorgewählte Frequenzstelle berechnet, wobei für jede Frequenzstelle Parameter der Admittanzmatrix jedes Verbindungsgliedes vor der eigentlichen Messung durch eine Kurzschlußmessung, eine Leerlaufmessung und eine Messung mit Normwiderstand bestimmt worden sind.

**4.** Anordnung nach Anspruch 3,
dadurch gekennzeichnet, daß die Auswerteschaltung (7) bei der Berechnung der Admittanzmatrix des Zweitorelementes (59) zusätzlich die Parameter der Admittanzmatrix (60) einbezieht, welche die Kopplung zwischen den Verbindungsgliedern (57, 58) beschreibt, wobei die Parameter dieser Admittanzmatrix vor der eigentlichen Messung durch eine Messung der Streumatrix an jeder Frequenzstelle bei leerlaufenden Anschlüssen der beiden Verbindungsglieder bestimmt worden sind.

**5.** Anordnung nach einem der vorhergehenden Ansprüche,
dadurch gekennzeichnet, daß die Auswerteschaltung (7)
- nacheinander alle Anfangswerte der Ersatzschaltbildelemente um einen Teil des Wertes verändert,
- nach der Veränderung eines Wertes die Admittanzmatrix des Zweitorelementes (59) oder die Impedanz des Eintorelementes (1) an jeder Frequenzstelle berechnet,
- das berechnete Ergebnis mit dem korrigierten Meßergebnis vergleicht,
- die Veränderung der Werte der Ersatzschaltbildelemente solange fortsetzt, bis die Abweichung zwischen dem korrigierten Meßergebnis und dem berechneten Ergebnis nicht weiter verringerbar ist und
- die zuletzt festgelegten Werte der Ersatzschaltbildelemente ausgibt (Fig. 4).

**6.** Anordnung nach einem der vorhergehenden Ansprüche,
dadurch gekennzeichnet, daß die Auswerteschaltung (7)
- die näherungsweise Bestimmung der Werte für die Ersatzschaltbildelemente für verschiedene Ersatzschaltbilder durchführt und
- die Werte der Ersatzschaltbildelemente für das Zweitorelement (59) bzw. Eintorelement (1) ausgibt, bei welchem die geringste Abweichung zwischen Meßergebnis und berechnetem Ergebnis auftritt.

**Claims**

**1.** An arrangement for determining approximatively the equivalent circuit diagram of an electric or electronic component at high frequencies, comprising a measuring apparatus (4) whereto a component representing a two-port element (59) is connected via connection members (57, 58, 60) or whereto a component representing a one-port element (1) is connected via a connection member (2) and which measures, in a preselected frequency range, the parameters of the stray matrix of the two-port element (59) or the impedance or the reflection factor of the one-port element (1) with the connection member or members (2; 57, 58, 60), characterized in that there is provided an evaluation circuit (7) which is connected to the measuring apparatus (4) and which
- corrects the measurement result by taking into account two-port parameters determined before the measurement of the connection member or members (2; 57, 58, 60), and
- calculates for an equivalent circuit diagram of the component (1, 59) values of the equivalent circuit diagram elements from the corrected measurement result by means of an optimization strategy.

**2.** An arrangement as claimed in Claim 1, <u>characterized in that</u> the evaluation circuit (7) calculates, from the measured impedance of the one-port element (1) with the connection member (2) and the parameters of the admittance matrix of the connection member, the impedance of the one-port element for each preselected frequency position, for each frequency position parameters of the admittance matrix having been determined before the actual measurement by a shortcircuit measurement, a no-load measurement and a measurement with a gauge resistor.

**3.** An arrangement as claimed in Claim 1, <u>characterized in that</u> the evaluation circuit (7) calculates, from the measured stray matrix of the two-port element (59) with the connection members (57, 58) and the parameters of the admittance matrix of each connection member, the parameters of the admittance matrix of the two-port element for each preselected frequency position, for each frequency position parameters of the admittance matrix of each connection member having been determined before the actual measurement by a shortcircuit measurement, a no-load measurement and a measurement with a gauge resistor.

**4.** An arrangement as claimed in Claim 3, <u>characterized in that</u> in calculating the admittance matrix of the two-port element (59) the evaluation circuit (7) additionally takes into account the parameters of the admittance matrix (60) describing the coupling between the connection members (57, 58), the parameters of this admittance matrix having been determined before the actual measurement by measurement of the stray matrix in each frequency position under no-load conditions of the connections of the two connection members.

**5.** An arrangement as claimed in any one of the preceding Claims, <u>characterized in that</u> the evaluation circuit (7)
- successively changes all initial values of the equivalent circuit diagram elements by a part of the value,
- calculates after the changing of a value, the admittance matrix of the two-port element (59) or the impedance of the one-port element (1) in each frequency position,
- compares the calculated result with the corrected measurement result,
- continues the changing of the values of the equivalent circuit diagram elements until the deviation between the corrected measurement result and the calculated result cannot be further reduced, and
- outputs the last values determined of the equivalent circuit diagram elements (Fig. 4).

**6.** An arrangement as claimed in any one of the preceding Claims, <u>characterized in that</u> the evaluation circuit (7)
- carries out the approximative determination of the values for the equivalent circuit diagram elements for several equivalent circuit diagrams, and
- outputs the values of the equivalent circuit diagram elements for the two-port element (59) and the one-port element (1) for which the smallest deviation occurs between the measurement result and the calculated result.

**Revendications**

**1.** Dispositif permettant de déterminer approximativement le schéma équivalent d'un composant électrique ou électronique à des fréquences élevées à l'aide d'un appareil de mesure (4) auquel un composant représentant un élément biporte (59) est connecté via des éléments de connexion (57, 58, 60) ou un composant représentant un élément monoporte (1) via un élément de connexion (2) et qui mesure sur un domaine de fréquences présélectionné les paramètres de la matrice de diffraction de l'élément biporte (59) ou l'impédance ou encore le facteur de réflexion de l'élément monoporte (1) avec le ou les élément(s) de connexion (2, 57, 58, 60), caractérisé en qu'un circuit d'évaluation (7) est prévu connecté à l'appareil de mesure (4), lequel circuit d'évaluation :
- corrige le résultat de la mesure par intégration des paramètres biporte du ou des élément(s) de connexion (2, 57, 58, 60) obtenus avant la mesure, et
- calcule pour un schéma équivalent du composant (1, 59), à partir du résultat de la mesure corrigée, les valeurs des éléments du schéma équivalent par une stratégie d'optimisation.

**2.** Dispositif selon la revendication 1, caractérisé en ce que le circuit d'évaluation (7) calcule, à partir de l'impédance mesurée de l'élément monoporte (1) avec l'élément de connexion (2) et les paramètres de la matrice d'admittance de l'élément de connexion, l'impédance de l'élément monoporte pour chaque position de fréquence présélectionnée, les paramètres de la matrice d'admittance ayant été déterminés pour chaque position de fréquence avant la mesure proprement dite par une mesure en court-circuit, une mesure en circuit ouvert et une mesure avec une résistance standard.

**3.** Dispositif selon la revendication 1, caractérisé en ce que le circuit d'évaluation (7) calcule, à partir de la matrice de diffraction mesurée de l'élément biporte (59) avec les éléments de connexion (57, 58) et les paramètres de la matrice d'admittance de chaque élément de connexion, les paramètres de la matrice d'admittance de l'élément biporte pour chaque position de fréquence présélectionnée, les paramètres de la matrice d'admittance de chaque élément de connexion ayant été déterminés pour chaque position de fréquence avant la mesure proprement dite par une mesure en court-circuit, une mesure en circuit ouvert et une mesure avec une résistance standard.

**4.** Dispositif selon la revendication 3, caractérisé en ce que le circuit d'évaluation (7) intègre en plus, lors du calcul de la matrice d'admittance de l'élément biporte (59), les paramètres de la matrice d'admittance (60) qui décrit le couplage entre les éléments de connexion (57, 58), les paramètres de cette matrice d'admittance ayant été déterminés avant la mesure proprement dite par une mesure de la matrice de diffraction dans chaque position de fréquence aux bornes ouvert des deux éléments de connexion.

**5.** Dispositif selon l'une quelconque des revendications précédentes, caractérisé en ce que le circuit d'évaluation (7) :
- modifie l'une après l'autre toutes les valeurs de départ des éléments du schéma équivalent d'une partie de la valeur;
- calcule après la modification d'une valeur la matrice d'admittance de l'élément biporte (59) ou l'impédance de l'élément monoporte (1) dans chaque position de fréquence;
- compare le résultat calculé au résultat de mesure corrigé;
- poursuit la modification des valeurs des éléments du schéma équivalent assez longtemps pour que l'écart entre le résultat de mesure corrigé et le résultat calculé ne puisse être réduit encore plus, et
- délivre les valeurs des éléments du schéma équivalent établies en dernier lieu (Fig. 4).

**6.** Dispositif selon l'une quelconque des revendications précédentes, caractérisé en ce que le circuit d'évaluation (7) :
- réalise la détermination approximative des valeurs des éléments du schéma équivalent pour divers schémas équivalents, et
- délivre les valeurs des éléments du schéma équivalent pour l'élément biporte (59) ou l'élément monoporte (1), pour lequel le plus faible écart entre le résultat de la mesure et le résultat calculé se présente.

**FIG.1**

**FIG.2**

**FIG. 3**

**FIG.5**

EP 0 349 043 B1

```
                    ┌──────────┐
                    │  R.L.C.  ├──── 20
                    └────┬─────┘
                    ┌────┴─────┐
                    │  d=0,05  ├──── 21
                    └────┬─────┘
                    ┌────┴─────┐
                    │ Index:=0 ├──── 22
                    └────┬─────┘
                    ┌────┴─────┐
                    │  F1:=F   ├──── 23
                    └────┬─────┘
                    ┌────┴──────┐
                    │ R1:= R + dR ├──── 24
                    └────┬──────┘
                    ┌────┴─────┐
                    │  F2:=F   ├──── 25
                    └────┬─────┘
```

F2 < F1?  26   N
R1:= R − dR  27
F2:= F  28
F2 < F1?  29   Y   N
Index:= 1  30
R:= R1  F1:=F2  31

C1:= C + dC  32
F2:=F  33
F2<F1?  34   N
C1:= C − dC  35
F2:= F  36
F2 < F1?  37   Y   N
Index:= Index + 1  38
C:= C1  F1:=F2  39

L1:= L + dL  40
F2:=F  41
F2 < F1?  42   N
L1:= L − dL  43
F2:=F  44
F2 < F1?  45   Y   N
L:= L1  F1:=F2  47
Index:= Index + 1  46

Index=3?  48   N   Y
d=0,05  49   Y   N
d=0,01  50
R.L.C.  51

**FIG.4**